# EUROPÄISCHE PATENTSCHRIFT

(11) **EP 2 089 730 B1**
(45) Veröffentlichungstag und Bekanntmachung des Hinweises auf die Patenterteilung: **15.08.2018**
(21) Anmeldenummer: 07822114.0
(22) Anmeldetag: 31.10.2007
(51) Int. Cl.: G01R 31/34, G01R 1/04, H01R 4/00

(54) **ELEKTRISCHE KONTAKTANORDNUNG**
ELECTRICAL CONTACT ARRANGEMENT
DISPOSITIF DE CONTACT ÉLECTRIQUE

(30) Priorität: 06.11.2006 DE 102006052112
(43) Veröffentlichungstag der Anmeldung: 19.08.2009
(73) Patentinhaber: Robert Bosch GmbH, 70442 Stuttgart (DE)
(72) Erfinder: LANG, Christian, 86551 Aichach (DE); HUBER, Daniel, 72762 Reutlingen (DE); SILBERBAUER, Achim, 72762 Reutlingen (DE); KIRCHER, Jochen, 72760 Reutlingen (DE); DILLMANN, Adolf, 72525 Muensingen (DE)
(86) Internationale Anmeldenummer: PCT/EP2007/061767
(87) Internationale Veröffentlichungsnummer: WO 2008/055839

(56) Entgegenhaltungen:
- DE-A1- 4 224 444
- US-A1- 2004 239 357
- US-A1- 2005 037 649
- US-B1- 6 344 753

## Beschreibung

Die Erfindung betrifft eine elektrische Kontaktanordnung mit einer Prüfkontaktstelle und einem einer Prüfeinrichtung angehörenden Kontaktierelement zum manuellen Berührungskontaktieren der Prüfkontaktstelle.

### Stand der Technik

Elektrische Kontaktanordnungen der eingangs genannten Art, wie in der Druckschrift US 2005/037649
beschrieben, sind weitläufig bekannt.

So gibt es beispielsweise Prüfgeräte, die eine oder mehrere Prüfnadeln aufweisen, welche manuell von einem Benutzer auf Kontaktplättchen eines zu prüfenden elektrischen/elektronischen Geräts gedrückt werden. Anschließend wird mittels eines Prüfstroms der ordnungsgemäße Betrieb des Geräts geprüft. Durch die auf das Kontaktplättchen gedrückte Prüfnadel entsteht dabei ein Punktkontakt, der die elektrische Verbindung herstellt. Bei einer derartigen Berührungskontaktierung sind aufgrund des Punktkontaktes nur geringe Ströme bis maximal 1 Ampere möglich. Die Verwendung von größeren Prüfnadeln verbessert dies nicht wesentlich.

### Offenbarung der Erfindung

Die erfindungsgemäße Lösung ergibt sich aus den Merkmalen des Patentanspruches 1. Weitere vorteilhafte Ausgestaltungen ergeben sich aus den Unteransprüchen.

### Kurze Beschreibung der Zeichnungen

Im Folgenden soll die Erfindung anhand einiger Figuren näher erläutert werden. Dazu zeigen im Folgenden:
- Figur 1: eine Draufsicht auf ein elektrisches/elektronisches Gerät mit erfindungsgemäßen Prüfkontaktstellen,
- Figur 2: eine Detailansicht einer Prüfkontaktstelle,
- Figur 3: eine erfindungsgemäße Kontaktanordnung,
- Figur 4: eine Detailansicht der erfindungsgemäßen Kontaktanordnung und
- Figur 5: einen Toleranzausgleich der erfindungsgemäßen Kontaktanordnung.

### Ausführungsform(en) der Erfindung

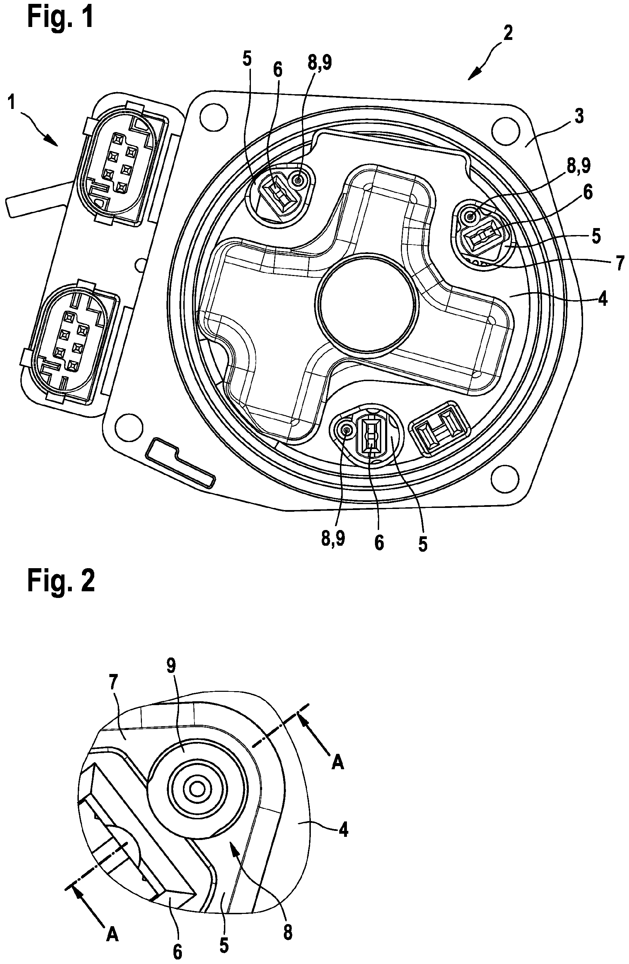

Die Figur 1 zeigt in einem Ausführungsbeispiel in einer Draufsicht als ein elektrisches/elektronisches Gerät 1 einen Elektromotor 2 der ein Gehäuse 3 aufweist, an dem ein Gehäusedeckel 4 angeordnet ist. Der Gehäusedeckel 4 weist drei Öffnungen 5 auf, die über Steckkontaktvorrichtungen 6 einer unter dem Gehäusedeckel 4 angeordneten Leiterplatte 7 angeordnet sind. Neben jeder der Steckkontaktvorrichtungen 6 ist jeweils eine Prüfkontaktstelle 8 vorgesehen, die als Ausnehmung 9 ausgebildet ist. Die Ausnehmungen 9 weisen dabei einen kreisförmigen Querschnitt auf. Die Öffnungen 5 sind derart geformt, dass die Prüfkontaktstelle 8 frei zugänglich ist, wie auch in einer Detailansicht der Prüfkontaktstelle 8 in der Figur 2 dargestellt.

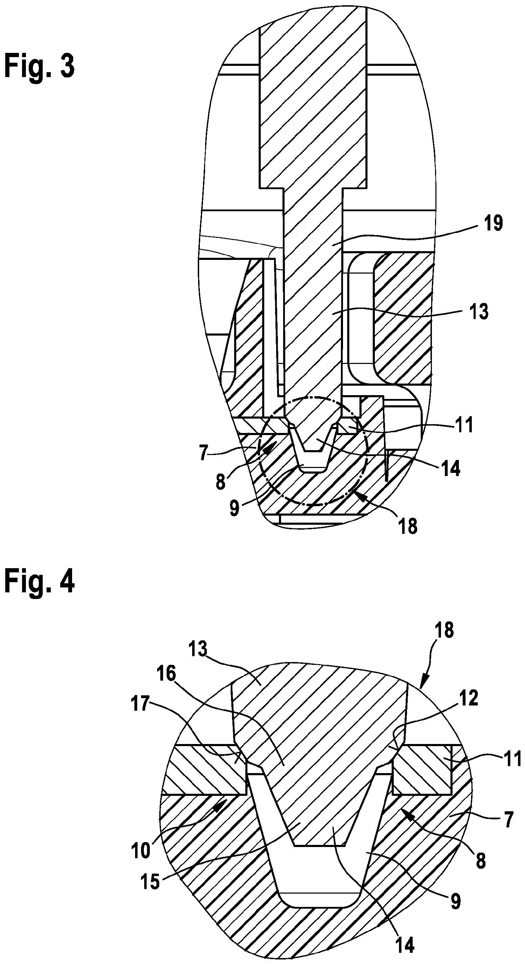

Die Figur 3 zeigt eine Schnittdarstellung der Prüfkontaktstelle 8 entlang eines Schnittes A-A aus der Figur 2, wobei ein Kontaktierelement 13 mit einer Kontaktspitze 14 in die Ausnehmung 9 geführt ist. Die Figur 4 zeigt dazu in einer Detailansicht die Kontaktspitze 14 des Kontaktierelements 13. Die Figur 4 zeigt weiterhin die Ausnehmung 9 in der Leiterplatte 7, wobei die Ausnehmung 9 kegelsegmentförmig ausgebildet ist. Im Randbereich 10 weist die Ausnehmung ein Leiterelement 11 beispielsweise einer Leiterbahn der Leiterplatte 7 auf. Das Leiterelement 11 bildet somit den elektrisch kontaktierbaren Bereich der Ausnehmung 9. Vorteilhafterweise weist das Leiterelement 11 eine kegelförmig ausgebildete Prüfkontaktfläche 12 auf, die somit einen kegelsegmentförmigen Abschnitt der Ausnehmung 9 bildet.

Die Kontaktspitze 14 des Kontaktierelements 13 ist kegelsegmentförmig ausgebildet und ragt in die Ausnehmung 9 hinein. Die Kontaktspitze 14 weist dabei einen ersten Kontaktspitzenbereich 15 auf, der kegelsegmentförmig ausgebildet ist, und einen zweiten Kontaktspitzenbereich 16, der ebenfalls kegelsegmentförmig ausgebildet ist, wobei sein kleinster Durchmesser größer ist als der größte Durchmesser des Kontaktspitzenbereichs 15. Die Durchmesser beider Bereiche nehmen entgegen der Einführrichtung des Kontaktierelements 13 in die Aufnahme 9 zu. Durch den Kontaktspitzenbereich 16 wird ein Kontaktbereich 17 des Kontaktierelements 13 gebildet, welcher mit der Ausnehmung 9 beziehungsweise dem Leiterelement 11 der Ausnehmung 9 einen vorteilhaften Flächenkontakt erzeugt. Der Kontaktspitzenbereich 15 dient hierbei als Einführhilfe für das Kontaktierelement 13 in die Ausnehmung 9.

Die durch das Kontaktierelement 13 und die Ausnehmung 9 gebildete elektrische Kontaktanordnung 18 ermöglicht es aufgrund des Flächenkontaktes einen Prüfstrom oberhalb von 10 Ampere, also im Hochstrombereich, für eine Prüfung des Gerätes 1 zu verwenden.

Figur 3 zeigt darüber hinaus eine vorteilhafte Gestaltung des Kontaktierelements als Prüfnadel 19. Durch die Nadelform kann das Kontaktierelement 13 beziehungsweise die Prüfnadel 19 besonders einfach auch an tiefergelegene Prüfkontaktstellen 8 gelangen. Durch die vorteilhafte Gestaltung der Kontaktspitze 14 wird die Prüfnadel 19 automatisch an der Prüfkontaktstelle 8 beziehungsweise in der Ausnehmung 9 ausgerichtet, wobei ein vorteilhafter Flächenkontakt erzeugt wird.

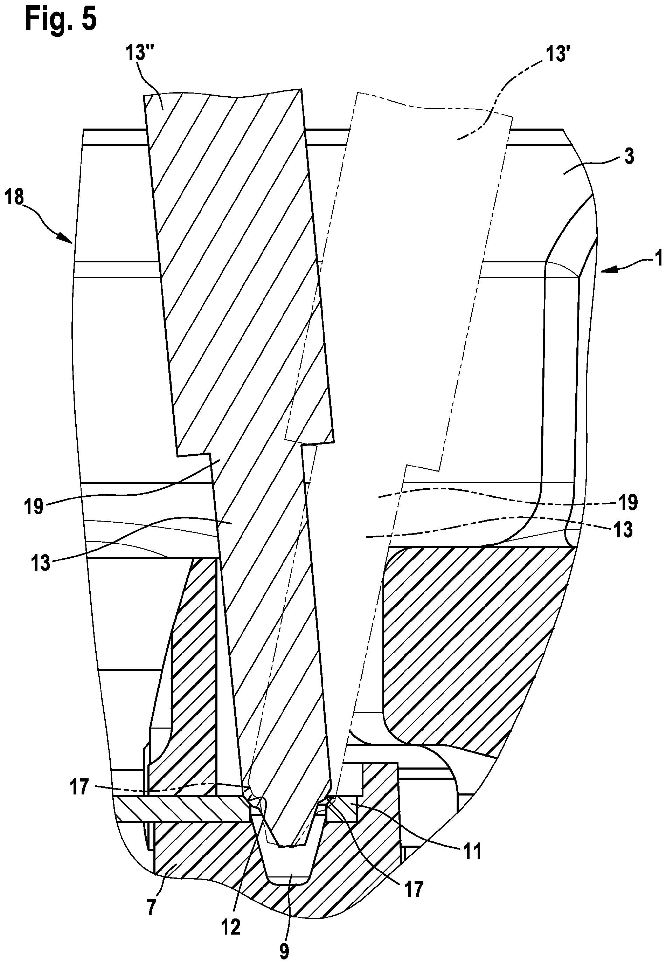

Die Figur 5 zeigt die Kontaktanordnung 18 aus den Figuren 3 und 4, wobei das Kontaktierelement 13 in zwei unterschiedlichen Positionen 13' und 13" dargestellt ist. Aufgrund der kegelsegmentförmigen Ausbildung der Ausnehmung 9 beziehungsweise der Prüfkontaktfläche 12 und dem Kontaktbereich 17 ist ein Toleranzausgleich möglich, wobei das Kontaktierelement 13 beziehungsweise die Prüfnadel 19 verkippt in die Ausnehmung 9 eingeführt und dennoch, zumindest bereichsweise, ein Flächenkontakt erzeugt wird.

Sind der Kontaktbereich 17 und die Prüfkontaktfläche 12 vorteilhafterweise kugelsegmentförmig ausgebildet, so bleibt die erzeugte Kontaktfläche beziehungsweise der erzeugte Flächenkontakt bei einer Verkippung des Kontaktierelements 13 beziehungsweise der Prüfnadel 19 in eine der Positionen 13' oder 13" stets gleich.

Weist die Ausnehmung 9 beziehungsweise das Leiterelement 11 keine formangepasste Prüfkontaktfläche auf, die wie in dem Ausführungsbeispiel dargestellt kegelsegmentförmig ausgebildet ist, so entsteht ein Linienkontakt, der ebenfalls einen höheren Stromfluss im Vergleich zum Stand der Technik zulässt.

Vorteilhafterweise ist in einer weiteren Ausführungsform der Kontaktanordnung 18 die Ausnehmung als ein Durchbruch, bevorzugt als eine Durchkontaktierung der Leiterplatte 7 ausgebildet.

## Patentansprüche

1. Elektrische Kontaktanordnung mit einer Prüfkontaktstelle und einem einer Prüfeinrichtung angehörenden Kontaktierelement zum manuellen Berührungskontaktieren der Prüfkontaktstelle, wobei die Prüfkontaktstelle (8) als Ausnehmung (9) ausgebildet ist, das Kontaktierelement (13) eine Kontaktspitze (14) aufweist, die zumindest bereichsweise kegel- oder kugelsegmentförmig ausgebildet ist, und das Kontaktierelement (13) einen zumindest einen Flächenkontakt mit der Ausnehmung (9) erzeugenden Kontaktbereich (17) aufweist, **dadurch gekennzeichnet, dass** der maximale Durchmesser der Kontaktspitze (14) größer als der maximale Durchmesser der Ausnehmung (9) ist, und dass die Kontaktspitze (14) einen ersten Kontaktspitzenbereich (15) aufweist, der kegelsegmentförmig ausgebildet ist, und einen zweiten Kontaktspitzenbereich (16) aufweist, der ebenfalls kegelförmig ausgebildet ist, wobei der kleinste Durchmesser des zweiten Kontaktbereichs (16) größer ist als der größte Durchmesser des ersten Kontaktspitzenbereichs (15).

2. Elektrische Kontaktanordnung nach Anspruch 1, **dadurch gekennzeichnet, dass** das Kontaktierelement (13) und/oder die Ausnehmung (9) einen kreisförmigen Querschnitt aufweisen.

3. Elektrische Kontaktanordnung nach einem der vorhergehenden Ansprüche, **dadurch gekennzeichnet, dass** ein Durchmesser des Kontaktierelements (13) kleiner als ein Durchmesser der Ausnehmung (9) ist.

4. Elektrische Kontaktanordnung nach einem der vorhergehenden Ansprüche, **dadurch gekennzeichnet, dass** die Kontaktspitze (14) den Kontaktbereich (17) aufweist.

5. Elektrische Kontaktanordnung nach einem der vorhergehenden Ansprüche, **dadurch gekennzeichnet, dass** die Ausnehmung (9) zumindest bereichsweise kegel- oder kugelsegmentförmig ausgebildet ist.

6. Elektrische Kontaktanordnung nach einem der vorhergehenden Ansprüche, **dadurch gekennzeichnet, dass** die Kontaktspitze (14) und die Ausnehmung (9) aufeinander formabgestimmt sind.

7. Elektrische Kontaktanordnung nach einem der vorhergehenden Ansprüche, **dadurch gekennzeichnet, dass** die Ausnehmung (9) nutenförmig ausgebildet ist.

8. Elektrische Kontaktanordnung nach einem der vorhergehenden Ansprüche, **dadurch gekennzeichnet, dass** die Kontaktspitze (14) ein Polyeder bildet.

9. Elektrische Kontaktanordnung nach einem der vorhergehenden Ansprüche, **dadurch gekennzeichnet, dass** die Ausnehmung (9) als Durchbruch ausgebildet ist.

10. Elektrische Kontaktanordnung nach einem der vorhergehenden Ansprüche, **dadurch gekennzeichnet, dass** der Durchbruch als Durchkontaktierung ausgebildet ist.

## Claims

1. Electrical contact arrangement comprising a test contact point and a contact-making element, which belongs to a test device, for making manual physical contact with the test contact point, wherein the test contact point (8) is designed as a recess (9), the contact-making element (13) has a contact tip (14) which is designed in the form of a segment of a cone or sphere at least in regions, and the contact-making element (13) has a contact region (17) which establishes at least surface contact with the recess (9), **characterized in that** the maximum diameter of the contact tip (14) is larger than the maximum diameter of the recess (9), and **in that** the contact tip (14) has a first contact tip region (15), which is designed in the form of a segment of a cone, and a second contact tip region (16), which is likewise designed in the shape of a cone, wherein the smallest diameter of the second contact region (16) is larger than the largest diameter of the first contact tip region (15).

2. Electrical contact arrangement according to Claim 1, **characterized in that** the contact-making element (13) and/or the recess (9) have/has a circular cross section.

3. Electrical contact arrangement according to either of the preceding claims, **characterized in that** a diameter of the contact-making element (13) is smaller than a diameter of the recess (9).

4. Electrical contact arrangement according to one of the preceding claims, **characterized in that** the contact tip (14) has the contact region (17).

5. Electrical contact arrangement according to one of the preceding claims, **characterized in that** the recess (9) is designed in the form of a segment of a cone or sphere at least in regions.

6. Electrical contact arrangement according to one of the preceding claims, **characterized in that** the contact tip (14) and the recess (9) are matched to one another in terms of shape.

7. Electrical contact arrangement according to one of the preceding claims, **characterized in that** the recess (9) is designed in the form of a groove.

8. Electrical contact arrangement according to one of the preceding claims, **characterized in that** the contact tip (14) forms a polyhedron.

9. Electrical contact arrangement according to one of the preceding claims, **characterized in that** the recess (9) is designed as an aperture.

10. Electrical contact arrangement according to one of the preceding claims, **characterized in that** the aperture is designed as a plated through-hole.

## Revendications

1. Agencement de contacts électriques, doté d'une zone de contact de contrôle et d'un élément de contact faisant partie d'un dispositif de contact, pour la mise en contact physique manuel de la zone de contact de contrôle, la zone de contact de contrôle (8) étant conçue sous la forme d'un évidement (9), l'élément de contact (13) comportant une pointe de contact (14) qui au moins par endroits est conçue sous la forme de segments coniques ou sphériques, et l'élément de contact (13) comportant une zone de contact (17) créant au moins un contact superficiel avec l'évidement (9), **caractérisé en ce que** le diamètre maximal de la pointe de contact (14) est supérieur au diamètre maximal de l'évidement (9) et **en ce que** la pointe de contact (14) comporte une première zone de pointe de contact (15) qui est conçue en forme de segment conique et une deuxième zone de pointe de contact (16) qui est également conçu sous forme conique, le plus petit diamètre de la deuxième zone de contact (16) étant supérieur au plus grand diamètre de la première zone de pointe de contact (15).

2. Agencement de contacts électriques selon la revendication 1, **caractérisé en ce que** l'élément de contact (13) et/ou l'évidement (9) présentent une section transversale de forme circulaire.

3. Agencement de contacts électriques selon l'une quelconque des revendications précédentes, **caractérisé en ce qu'**un diamètre de l'élément de contact (13) est inférieur à un diamètre de l'évidement (9).

4. Agencement de contacts électriques selon l'une quelconque des revendications précédentes, **caractérisé en ce que** la pointe de contact (14) comporte la zone de contact (17).

5. Agencement de contacts électriques selon l'une quelconque des revendications précédentes, **caractérisé en ce que** l'évidement (9) est conçu au moins par endroits sous forme de segment conique ou sphérique.

6. Agencement de contacts électriques selon l'une quelconque des revendications précédentes, **caractérisé en ce que** la pointe de contact (14) et l'évidement (9) ont une forme réciproquement adaptée.

7. Agencement de contacts électriques selon l'une quelconque des revendications précédentes, **caractérisé en ce que** l'évidement (9) est conçu sous forme de rainure.

8. Agencement de contacts électriques selon l'une quelconque des revendications précédentes, **caractérisé en ce que** la pointe de contact (14) forme un polyèdre.

9. Agencement de contacts électriques selon l'une quelconque des revendications précédentes, **caractérisé en ce que** l'évidement (9) est conçu sous la forme d'un ajour.

10. Agencement de contacts électriques selon l'une quelconque des revendications précédentes, **caractérisé en ce que** l'ajour est conçu sous la forme d'une connexion traversante.
